# EUROPÄISCHE PATENTANMELDUNG

(11) **EP 1 790 953 A1**
(43) Veröffentlichungstag der Anmeldung: **30.05.2007**
(21) Anmeldenummer: 05110357.0
(22) Anmeldetag: 04.11.2005
(51) Int. Cl.: G01D 5/347, H01L 27/30

(54) **Optoelektrische Winkelmesseinrichtung**

(71) Anmelder: Leica Geosystems AG, 9435 Heerbrugg (CH)
(72) Erfinder: Aebischer, Beat, CH-9435 Heerbrugg (CH); Lippuner, Heinz, CH-9445 Rebstein (CH); Braunecker, Bernhard, CH-9445, Rebstein (CH)
(74) Vertreter: Büchel, Kaminski & Partner

(57) **Zusammenfassung**

Eine erfindungsgemässe optoelektrische Winkelmesseinrichtung weist einen Codeträger mit einem optisch erfassbaren Positionscode (C1), sowie eine Abtasteinrichtung mit lichtempfindlichen Flächenbereichen zum Erfassen des Positionscodes (C1) und Erzeugen eines positionsabhängigen Abtastsignals auf. Die, insbesondere als Abtastfolie (F1) ausgebildete, Abtasteinrichtung umgreift den Codeträger oder der Codeträger die Abtasteinrichtung entlang dessen/deren Umfangsfläche zumindest entlang eines Teilabschnitts, insbesondere sogar vollständig. Damit wird eine äusserst genaue Winkelmesseinrichtung bereitgestellt, indem ein grosser Ausschnitt des Positionscodes (C1) und gegebenenfalls sogar der gesamte Positionscode (C1) erfassbar ist.

## Beschreibung

Die Erfindung betrifft eine optoelektrische Winkelmesseinrichtung zur Bestimmung mindestens eines Winkels um mindestens eine Achse.

Das Bestimmen von Richtungen und Winkeln ist in vielen Anwendungsbereichen, wie beispielsweise in der geodätischen und industriellen Vermessung, gefordert. Entwicklungen in der Winkelmesstechnik führen über mechanische Ablesevorgänge bis zur vollautomatisierten Winkelmessung im heutigen Stand der Technik. Mit der Automatisierung sind höhere Messgenauigkeiten erzielbar, Beobachtungszeiten verkürzbar sowie Messwerte direkt abspeicherbar und in digitaler Form weiterverarbeitbar.

Bekannte Winkelmessvorrichtungen umfassen im Allgemeinen einen sogenannten Teilkreis und eine Abtasteinrichtung. Der Teilkreis ist als Codeträger ausgebildet, er weist eine Teilung oder Codierung zur Positionsbestimmung am Kreis auf. Eine zur Winkelbestimmung mit Teilung oder Codierung ausgebildete Vorrichtung wird im Folgenden als Codeträger oder als Teilkreis bezeichnet. Die Codierung ist auf einer Oberfläche - Kreis- oder Mantelfläche - des Codeträgers aufgebracht.

Zur automatischen Erfassung der Winkelwerte wird der relativ zur Abtasteinrichtung um eine Achse drehbare Codeträger mittels unterschiedlicher Techniken abgetastet. Bekannte Abtastverfahren sind elektronisch-magnetische, elektrische und optisch-elektronische Verfahren. Die folgenden Ausführungen beziehen sich auf optisch-elektronische Abtastverfahren und Abtasteinrichtungen.

Zur Bestimmung von Winkelstellungen von 0° bis 360° ist die Codierung üblicherweise in einem Vollkreis angeordnet. Die Winkelauflösung des Vollkreises bestimmt sich nach Art der Codierung und nach der zum Lesen der Codierung eingesetzten Abtasteinrichtung. So wird beispielsweise durch Aufbringen eines Codes in mehreren Spuren oder durch eine feinere Teilung die Winkelauflösung gesteigert, wobei die erreichbare Auflösung aus fertigungs- und kostentechnischen Gründen beschränkt ist. Zum Lesen des Codes sind z.B. Anordnungen von einem oder mehreren Abtastelementen am Teilkreis bekannt. CCD-Zeilen-Arrays oder CCD-Flächen-Arrays können beispielsweise solche Abtastelemente darstellen.

Nachdem derartige Abtasteinrichtungen jeweils nur einen kleinen Codebereich erfassen können, sind zum Erreichen der geforderten Messgenauigkeiten - die für geodätische Anwendungen beispielsweise im Bereich < 3 mgon liegen - verschiedene Verfahren und Vorrichtungen entwickelt worden. So ist es insbesondere üblich, eine Grobmessung mit einer Feinmessung zu kombinieren bzw. durch Interpolation und rechnerische Auswertung die geforderte Auflösung zu erreichen und Messfehler zu reduzieren. Diesbezügliche Winkelmessvorrichtungen umfassen z.B. zusätzliche Codierungen, Abtastgitter oder mehrere Abtaster zur Mehrfachabtastung. Derartige bekannte Lösungen sind jedoch technisch komplex und kostenintensiv oder stellen Kompromisse zwischen Messgenauigkeit und Messgeschwindigkeit dar.

Eine Aufgabe der Erfindung ist die Bereitstellung einer Winkelmesseinrichtung, welche eine Reduktion technischer Komplexität bei Einhaltung der gattungsgemäss erforderlichen Messgenauigkeit ermöglicht.

Eine weitere Aufgabe ist die Bereitstellung einer Winkelmesseinrichtung zur Durchführung von Winkelmessungen mit grösserer Genauigkeit.

Diese Aufgaben werden durch die Verwirklichung der kennzeichnenden Merkmale des Anspruchs 1 sowie durch die kennzeichnenden Merkmale der Unteransprüche gelöst bzw. die Lösungen weitergebildet.

Erfindungsgemäss wird eine Winkelmesseinrichtung mit einem Codeträger sowie einer Abtasteinrichtung bereitgestellt, wobei mittels der Abtasteinrichtung ein grösserer codierter Bereich des Codeträgers, insbesondere sogar der gesamte codierte Bereich, erfassbar ist. Damit ist einerseits die Positionsbestimmung mit einem weniger komplexen Code möglich, andererseits sind Redundanzinformationen gewinnbar, indem ein grösserer Bereich als zur eindeutigen Positionsbestimmung erforderlich erfasst wird. Durch die zusätzliche Messinformation ist eine zuverlässige Messung gewährleistet. Weiters wird mit der Erfassung eines grösseren Codebereichs - gegebenenfalls von 360° - die Messgenauigkeit gesteigert, beispielsweise durch Integration über eine grössere Anzahl von Messwerten.

Das Erfassen des codierten Bereichs wie vorgängig beschrieben erfolgt mittels einer Abtasteinrichtung, die derart ausgebildet ist, dass sie entlang des inneren oder äusseren Umfangs des Codeträgers angeordnet ist, sodass die Abtastvorrichtung den Codeträger oder der Codeträger die Abtastvorrichtung zumindest teilweise - und gegebenenfalls vollständig - umgreift, beispielsweise in einem Winkel > 45° oder insbesondere > 270°. Unter einem Bereich ist im Rahmen der Erfindung auch gegebenenfalls ein einzelnes punkt- oder linienförmiges Element, wie ein Strich, zu verstehen.

Die Anordnung von Codeträger und Abtasteinrichtung ist derart, dass eine Relativ-Drehbewegung zwischen denselben ermöglicht wird. Die Drehbewegung erfolgt um eine Achse des Codeträgers und/oder der Abtasteinrichtung. Im Allgemeinen umgeben Codeträger und Abtasteinrichtung dieselbe Achse, wobei der Begriff Umgeben auch ein teilweises Umgeben umfasst. Z.B. ist der Codeträger um eine Achse - Drehachse - drehbar angeordnet und dreht sich mit einem Element, dessen Winkelstellung erfasst werden soll, mit, während die Abtasteinrichtung fix positioniert ist, oder aber die Abtasteinrichtung dreht sich mit, während der Codeträger fest ist.

Der Codeträger oder Teilkreis weist insbesondere eine geometrische Form mit kreisförmigem Querschnitt auf, z.B. die Form eines Zylinders oder Hohlzylinders. Ebenso kann der Codeträger als Kreissegment ausgebildet sein. Er kann aus Glas, Kunststoff oder anderem optisch transparenten Material, sowie auch aus nicht-transparentem Material mit Schlitzen und/oder Löchern gefertigt sein. Die Ausbildung aus optisch nicht durchlässigem Material ist ebenfalls möglich, wenn die optische Messung mittels am Codeträger reflektierter optischer Signale erfolgt. In einer vorteilhaften Ausführungsform der Erfindung ist ein optisch erfassbarer Positionscode auf eine - zur Achse parallele - Umfangsfläche/Mantelfläche des Codeträgers aufgebracht. Unter dem Begriff Positionscode sind optisch erfassbare Mittel zusammengefasst, wobei durch das optische Erfassen der Mittel ein positionsabhängiges Signal erzeugbar ist. Die Positionsabhängigkeit kann dabei aus der Codierung oder aus der Detektionsposition abgeleitet werden. Anhand des Signals ist in weiterer Folge - mittel- oder unmittelbar - ein absoluter oder relativer Positionswert feststellbar.

Nachdem mit der erfindungsgemässen Winkelmesseinrichtung - je nach gewählter Ausführungsform - Codebereiche zwischen 0° und 360° erfassbar sind, kann sich der Positionscode aus mehreren in Umfangs- und/oder Achsrichtung beabstandeten Markierungen oder nur einer einzigen Markierung zusammensetzen. Das Ableiten von Positionsinformation ist beispielsweise nach Kalibrierung einer, einen Winkelbereich von 360° erfassenden, Abtasteinrichtung aus der Detektionsposition des Positionscodes auf der Abtasteinrichtung möglich, wobei der Positionscode als einzelnes Codeelement, z.B. als Strich, oder der Codeträgers selbst als Strichelement ausgeführt sein kann.

Eine auf die Mantel-Oberfläche aufgebrachte oder in die Oberfläche eingebrachte Strichteilung als Positionscode stellt bei inkrementeller Strichteilung einen Codeträger zur Messung von Relativwerten bereit. Oftmals ist ein derartiger Codeträger mit einer Grob- und einer Feinteilung versehen. Auf einen Glaskreis sind Teilungen mit Strichbreiten im Mikrometerbereich aufbringbar, welche mit freiem Auge nicht sichtbar, mittels einer optischen Anordnung aber erfassbar sind. Während früher das Aufbringen von Teilungen mittels Ritzen, Ätzen, Schwärzen oder Gravieren erfolgte, werden heute im Allgemeinen photomechanische Kopierverfahren, insbesondere photolithographische Verfahren verwendet.

Ein zur absoluten Messwertgebung ausgebildeter Codeträger ist mit einem Absolutcode ausgeführt. Der Code kann in einer oder mehreren konzentrischen Spuren auf der Mantelfläche des Codeträgers angeordnet bzw., insbesondere mittels Photolithographie, aufgebracht sein. Ebenso kann die Mantelfläche einen sich in Umfangs- und Achsrichtung erstreckenden Code aufweisen, beispielsweise einen die Achse spiralförmig umgebenden Code. Die Gestaltungsmöglichkeiten für die Codierung eines Codeträgers einer Winkelmesseinrichtung sind jedoch vielfältig und einem Fachmann bekannt und werden deshalb nicht im Detail und vollen Umfang ausgeführt.

Zum Erfassen bzw. Erzeugen positionsabhängiger Abtastsignale weist die erfindungsgemässe Winkelmesseinrichtung eine Abtasteinrichtung zum Abtasten des Positionscodes auf. Die Abtasteinrichtung ist so ausgebildet und angeordnet, dass sie den Codeträger zumindest entlang eines Teilumfangs desselben umgreift, wobei die umgriffene Teilumfangs-Fläche den Positionscode aufweist. Ebenso kann die Anordnung so gewählt werden, dass der Codeträger die Abtasteinrichtung umgreift. Die optische Erfassung des Positionscodes bzw. eines Teils davon erfolgt mittels lichtempfindlicher Bereiche der Abtasteinrichtung. Durch beispielsweise von einer Beleuchtungseinrichtung bereitgestellte, optische Strahlung ist der Positionsode - zumindest teilweise - auf den Bereichen abbildbar. Vorteilhaft kann die Abtasteinrichtung um den gesamten Umfang des Codeträgers angeordnet werden, womit eine Erfassung und Integration über die gesamte - mittels des Codeträgers bereitgestellte - Winkelinformation ermöglicht wird. Damit sind Winkelmessungen mit grösserer Präzision durchführbar. Bei inkrementellem Code ist weiters eine entsprechend gekennzeichnete Anfangs- und End-Stellung immer feststellbar. Auch können weitere Fehlerquellen, wie beispielsweise Kreisteilfehler, durch Abbildung der gesamten Teilkreis-Codierung festgestellt und entsprechend korrigiert werden. Bei der Gesamt-Abbildung ist ausserdem eine eindeutige Codezuordnung jederzeit gewährleistet, womit gegebenenfalls auf Codeelemente verzichtet werden kann. Damit sind in erfindungsgemässen Winkelmesseinrichtungen Codeträger mit weniger komplexen Codes einsetzbar, was fertigungs- und kostentechnische Erleichterungen darstellt.

Die lichtempfindlichen Bereiche der Abtasteinrichtung können zeilenförmig in Umfangsrichtung und/oder Achsrichtung des Codeträgers angeordnet sein. Zur Erfassung eines grösseren Codebereichs sind Flächenbereiche vorzugsweise matrixförmig angeordnet. So ist eine Vielzahl lichtempfindlicher organischer Photodioden in einer transparenten Polymer-Matrix als Abtasteinrichtung einsetzbar. Bevorzugt ist eine optisch transparente oder teiltransparente Abtastfolie einsetzbar. Ist die Folie gegenüber dem Codeträger entsprechend angeordnet, so wird auf den Codeträger treffende optische Strahlung - je nach Ausführung des Codeträgers bzw. des Codes - als reflektierte oder durchgelassene Strahlung von den lichtempfindlichen Bereichen detektiert. Beispielsweise wird reflektiertes oder transmittiertes Licht von mehreren organischen Photodioden als lichtempfindliche Bereiche empfangen und als elektrische Spannung ausgegeben. Die Spannungswerte sind in der Folge digitalisierbar und als digitale Werte weiterverarbeitbar. Mit in Massenproduktion hergestellten Abtastfolien ist eine äusserst kostengünstige und dennoch hochpräzise Abtasteinrichtung gegeben.

Eine für eine Abtasteinrichtung geeignete Abtastfolie ist beispielsweise in dem auf den Seiten 22,23 in der Ausgabe des Wissenschaftsmagazins OLE (Opto & Laser Europe) vom Februar 2005 erschienen Artikel "Pocket scanner has curved surfaces wrapped up" beschrieben. Die auch als "sheet image-scanner" oder "image-scanner film" bezeichnete Abtastfolie ist als dünne Kunststoff-Folie ausgebildet und enthält ein Feld lichtempfindlicher Kunststoff-Sensoren, sogenannter organischer Photodioden, die mittels Silberpaste mit einem Feld organischer Transistoren verbunden sind. Diese Verwendung organischer Halbleiter bietet die Möglichkeit der einfachen und grossflächigen Herstellung, beispielsweise mittels Druck- oder Aufdampftechniken, sowie ein robustes und flexibles Endprodukt.

Angeordnet ist die Abtasteinrichtung gegenüber dem codierten Flächenbereich des Codeträgers derart, dass die Abtasteinrichtung den codierten Bereich oder der codierte Bereich die Abtasteinrichtung wenigstens teilweise umgreift. Unter dem Begriff umgreifen ist - bei umgreifender Abtasteinrichtung - eine Anordnung zu verstehen, bei welcher eine Teilumfangsfläche der Abtasteinrichtung eine Teilumfangsfläche des Codeträgers derart umgibt, dass die umgebene Teilumfangsfläche des Codeträger in den von der Teilumfangsfläche der Abtasteinrichtung aufgespannten Raum hineinragt und sich die beiden Teilumfangsflächen in berührungsfrei beabstandeter, einen Zwischenraum bildender, Gegenüberlage befinden. Ein vollständiges Umgreifen zweier 360°-Umfangsflächen ist im Querschnitt durch zwei konzentrische Kreise darstellbar.

Die Möglichkeiten der Anordnung von Abtasteinrichtung und Codeträger umfassen beispielsweise eine den Codeträger entlang dessen gesamten Umfangs umgreifende Abtasteinrichtung. Ebenso kann der Codeträger die Abtasteinrichtung entlang deren Umfangs umgreifen. Ebenso sind Anordnungen entlang eines Teilumfangs denkbar. Die Abtasteinrichtung kann ein- oder mehrstückig ausgeführt sein. Im mehrstückigen Fall ist eine symmetrische oder asymmetrische Anordnung der mehreren Einrichtungen um den Codeträger möglich. Weiters können auch quer zur Umfangsrichtung mehrere Abtasteinrichtungen angeordnet sein, beispielsweise für grob- und feinkodierte Spuren. In ihrer flächigen Ausdehnung parallel zur Drehachse können Codeträger und Abtasteinrichtung einander entsprechen oder sich unterscheiden. Mit einer Abtasteinrichtung, deren Ausdehnung die des Codeträgers übertrifft, sind beispielsweise Bewegungen in Richtung der Drehachse feststellbar.

Das optische Erfassen des Positionscodes mittels Umgebungslicht ist für eine - entsprechend viel Umgebungslicht empfangende - erfindungsgemässe optisch-elektronische Winkelmesseinrichtung mit Codeträger und Abtasteinrichtung möglich. Nachdem eine Winkelmesseinrichtung aber meist in ein Messgerät integriert ist, ist im Allgemeinen eine Beleuchtungseinrichtung vorzusehen. Diese kann mittig in einem optisch transparenten Codeträger angeordnet sein, diesen also von innen beleuchten. Die aussen um den Umfang des Codeträgers angeordnete Abtasteinrichtung erfasst durchtretendes Licht - die Abtastung erfolgt dann mittels des sogenannten Durchlichtverfahrens. Beim Durchlichtverfahren wird der Codeträger - beispielsweise ein Glaszylinder - mit lichtdurchlässigen und lichtundurchlässigen Bereichen kodiert. Von einer Seite wird die Codierung beleuchtet, auf der anderen Seite ist die Abtasteinrichtung als Empfangseinrichtung angeordnet. Der Codeträger befindet sich also zwischen Beleuchtungseinrichtung und Empfangseinrichtung. Im Gegensatz dazu kann aber auch das sogenannte Auflichtverfahren zur Abtastung eingesetzt werden. Für das Auflichtverfahren sind Beleuchtungs- und Empfangseinrichtung auf derselben Seite des Codeträgers angeordnet. Dieser ist teilweise reflektierend ausgebildet bzw. weist unterschiedliche Reflexionseigenschaften auf, sodass unterschiedliche Strahlintensitäten registriert werden.

Ist die Abtasteinrichtung optisch transparent oder teilweise transparent, beispielsweise mit lichtdurchlässigen Bereichen zwischen den lichtempfindlichen Bereichen, so kann die Auflichttechnik auch angewendet werden, indem der Codeträger durch die zumindest teilweise transparente Abtasteinrichtung hindurch beleuchtet wird. Die Beleuchtung kann auch schräg in den Zwischenraum zwischen Codeträger und Abtasteinrichtung erfolgen. Einige Möglichkeiten der Beleuchtung bzw. der Beleuchtungsanordnung sind als Ausführungsbeispiele in den Figuren dargestellt.

Die Wahl der Beleuchtungseinrichtung - wie Laserdiode, Lichtleiter, diffuse Strahlung - trifft der Fachmann insbesondere nach fertigungs- und/oder kostentechnischen Gesichtspunkten. Auch wird die Wahl im Allgemeinen von der gewünschten Anordnung der Beleuchtungseinrichtung relativ zu Codeträger und Abtasteinrichtung abhängen.

Ein Einsatzbereich für erfindungsgemässe Winkelmesseinrichtungen sind geodätische Messinstrumente mit der Funktion der Richtungs- und Winkelbestimmung. So sind beispielsweise Theodoliten mit horizontalem und vertikalem Teilkreis und entsprechenden Ableseeinrichtungen ausgestattet, um Horizontal- und Vertikalwinkel mit höchster Genauigkeit messen zu können.

Die erfindungsgemässe Winkelmesseinrichtung wird nachfolgend anhand von in den Zeichnungen schematisch dargestellten Ausführungsbeispielen rein beispielhaft näher beschrieben. Im Einzelnen zeigen
- Fig. 1A: eine erste Winkelmesseinrichtung nach dem Stand der Technik mit vier Abtasteinheiten;
- Fig. 1B: eine zweite Winkelmesseinrichtung nach dem Stand der Technik mit fünf Lumineszenz- und Photodioden;

- Fig. 2: eine Ausführungsform eines Codeträgers für eine erfindungsgemässe Winkelmesseinrichtung;
- Fig. 3A-3D: Ausführungsformen erfindungsgemässer Winkelmesseinrichtungen mit alternativen Anordnungen und Ausbildungen von Codeträger und Abtasteinrichtung;
- Fig. 4A, 4B: zwei Ausführungsformen einer erfindungsgemässen Winkelmesseinrichtung mit einem Codeträger mit spiralförmigem Code;
- Fig. 5A-5D: in vier Teilfiguren mögliche Anordnungen von Beleuchtungseinrichtungen erfindungsgemässer Winkelmesseinrichtungen;
- Fig. 6a-6D: in vier Teilfiguren schematisch mögliche Anordnungen von Codeträger und Abtasteinrichtung;
- Fig. 7A: ein erstes Ausführungsbeispiel einer erfindungsgemässen Winkelmesseinrichtung zur Messung der Winkellage eines Kugelgelenks; und
- Fig. 7B: ein zweites Ausführungsbeispiel einer erfindungsgemässen Winkelmesseinrichtung zur Messung der Winkellage eines Kugelgelenks.

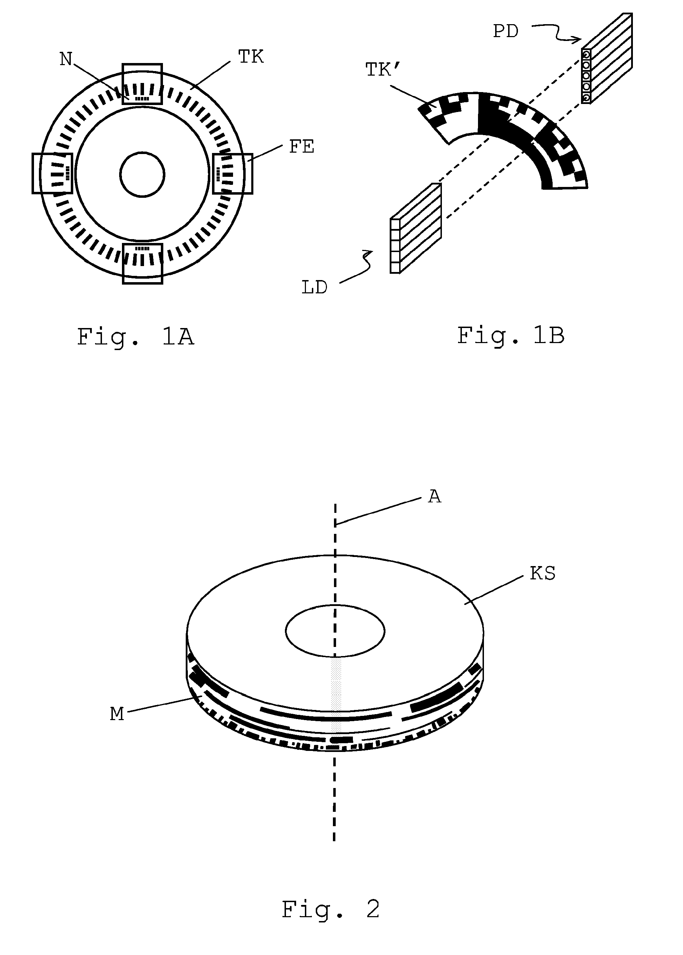

Figur 1A zeigt eine Anordnung zum Einstellen von Winkellagen nach dem Stand der Technik. Die Anordnung weist einen - eine inkrementale Strichteilung aufweisenden - Teilkreis TK mit vier Nullmarkierungen N und vier Abtasteinheiten auf. Die zwei Paar einander diametral gegenüberliegenden Photoelemente FE als Abtasteinheiten sowie die zwei Paar einander gegenüberliegenden Nullmarkierungen N sind zum Einstellen genauerer Winkellagen vorgesehen, insbesondere zur Vermeidung von zyklischen, periodischen Fehlern.

Eine weitere optisch-elektronische Winkelmess-Anordnung nach dem Stand der Technik ist in Figur 1B dargestellt. Die Winkelmess-Anordnung ist zur groben Absolutwinkelmessung ausgebildet. Dazu ist ein Teilkreis TK' mit fünf konzentrischen Codespuren ausgeführt. Zum Abtasten der Spuren sind fünf Lumineszenzdioden LD sowie fünf Photodioden PD senkrecht zur Umfangsrichtung an einander gegenüberliegenden Kreisseiten als Lichtschranken angeordnet. Je nach Lichtdurchlässigkeit bzw. Lichtundurchlässigkeit der jeweiligen Codespur wir ein Signal (hell/dunkel) und daraus ein Binärzeichen (1/0) erzeugt.

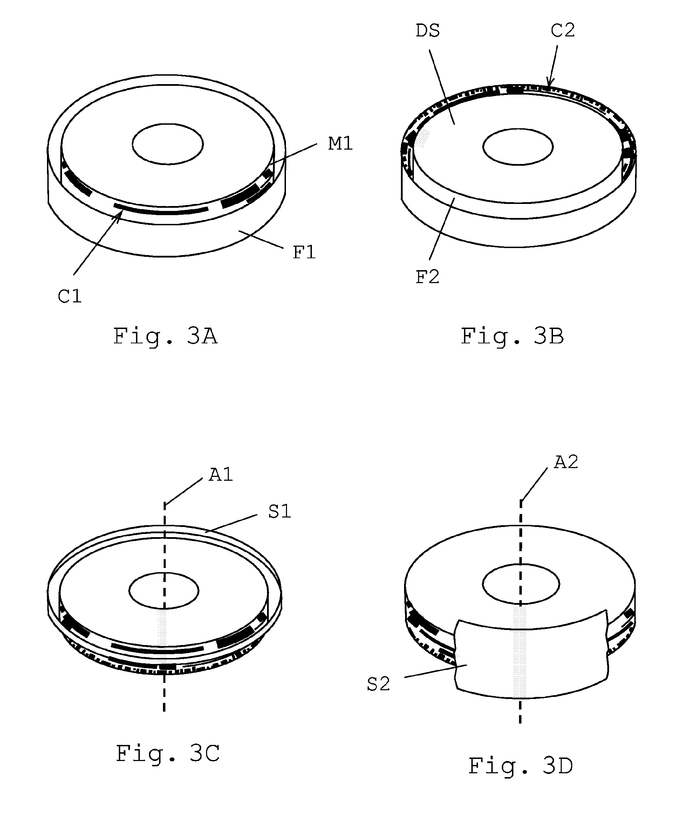

Figur 2 stellt eine Ausführungsform eines in einer erfindungsgemässen Winkelmesseinrichtung einsetzbaren Codeträgers dar. Der Codeträger ist als um eine Achse A drehbare Kreisscheibe KS ausgebildet, wobei der Code entlang der Umfangsfläche - Mantelfläche - der Kreisscheibe KS aufgebracht ist. Die Darstellung des Codes ist - auch im Folgenden - rein beispielhaft.

Die Figuren 3A-3D zeigen erfindungsgemässe Winkelmesseinrichtungen mit unterschiedlichen Ausbildungen und Anordnungen von Codeträger und Abtasteinrichtung und werden zusammenhängend beschrieben.

In Figur 3A ist der Codeträger scheibenförmig mit auf der Umfangsfläche/Mantelfläche M1 aufgebrachtem Positionscode C1 ausgebildet. Eine Abtastfolie F1 als Abtasteinrichtung umgreift den Codeträger entlang dessen gesamten Umfangs. Figur 3B zeigt einen Codeträger, welcher die Abtastfolie F2 entlang deren gesamten Umfangs umgreift - die Abtastfolie F2 ist entlang des inneren Umfangs des Codeträgers angeordnet, wobei die Abtastfolie hier auf der Umfangfläche/Mantelfläche einer Drehscheibe DS befestigt ist. Der Codeträger trägt einen Positionscode C2 entsprechend entlang seines inneren Umfangs. Codeträger und Abtastfolie F1, F2 in den Figuren 3A und 3B sind jeweils konzentrisch so angeordnet, dass die Umfangsfläche des Codeträgers in dem von der Umfangsfläche der Abtastfolie F1 aufgespannten Raum (Fig. 3A) liegt oder die Umfangsfläche der Abtastfolie F2 in dem von der Umfangsfläche des Codeträgers aufgespannten Raum liegt (Fig. 3B), wobei Codeträger und Abtastfolie F1, F2 durch einen Zwischenraum beabstandet sind. Die Abtastfolie F1, F2 ist jeweils einstückig ausgebildet und weist eine Vielzahl - nicht dargestellter - organischer, matrixartig angeordneter Photodetektoren auf, das Codeträger-Material ist hier Kunststoff.

In den Figuren 3C und 3D ist eine, lichtempfindliche Bereiche aufweisende, Kunststoff-Folie um einen Codeträger angeordnet, wobei Kunststoff-Folie und Codeträger jeweils um eine Achse A1,A2 angeordnet sind. Die Kunststoff-Folie S1 aus Figur 3C ist zeilenförmig um den Umfang des Codeträgers angeordnet und weist eine geringere Ausdehnung in Achsrichtung auf als der Codeträger. Hingegen ist die Ausdehnung der Folie S2 aus Figur 3D in Achsrichtung grösser als die des Codeträgers. In beiden Figuren umgreift also die Abtasteinrichtung den Codeträger, sodass der Codeträger in dem von der Umfangsfläche der Abtasteinrichtung aufgespannten Raum liegt. Der von der Umfangsfläche aufgespannte Raum ist der von der Umfangsfläche eingeschlossene Raum, welcher Raum auch die Achse A1,A2 des Codeträgers bzw. der Abtasteinrichtung einschliesst. So kann die erfindungsgemässe Winkelmesseinrichtung je nach gewünschter/bevorzugter Eigenschaft - z.B. Messgenauigkeit, Kompaktheit der Anordnung, Kosten und Komplexität der Herstellung - ausgebildet und angeordnet sein.

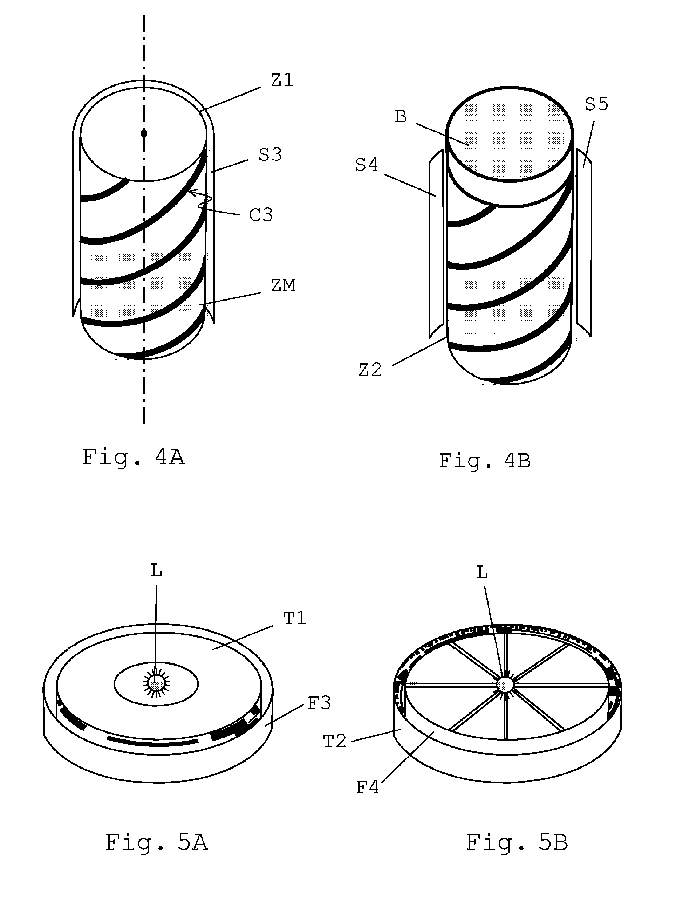

Die Figuren 4A und 4B zeigen als weitere Ausführungsform einer erfindungsgemässen optoelektrischen Winkelmesseinrichtung in Figur 4A einen Codeträger mit zylindrischem Drehkörper Z1, wobei der Codeträger auf der Zylinder-Mantelfläche ZM als Positionscode einen spiralförmigen Code C3 trägt. Eine Detektionsfolie S3 umgreift den Drehkörper als Abtasteinrichtung entlang dessen gesamter Höhe und in dieser Ausführungsform entlang dessen halben Umfangs.

In Figur 4B sind auf zwei gegenüberliegenden Seiten eines Hohlzylinder-Codeträgers Z2 zwei Folien S4,S5 angeordnet. Weiters ist ein Beleuchtungselement B dargestellt. Das Beleuchtungselement B weist eine aufgeraute, optisch transparente Grundplatte auf, sodass Licht einer Lichtquelle der Beleuchtungseinrichtung B durch die als Diffusor wirkende Grundplatte diffus ins Innere des Hohlzylinders gestreut wird. So wird der Codeträger von innen homogen beleuchtet und mittels des Durchlichtverfahrens anhand der Folien S4, S5 abgetastet. Im Vergleich zu den vorherigen Ausführungsformen weisen die Ausführungsformen von Codeträger und Abtasteinrichtung der Figuren 4A und 4B einen geringeren Durchmesser und eine grössere Erstreckung in Achsrichtung auf. Für eine solche Ausbildung einer erfindungsgemässen Winkelmesseinrichtung sind gegebenenfalls auch längliche Beleuchtungseinrichtungen, beispielsweise Glasfaser-Lichtleiter, einsetzbar.

Auch in den weiteren Figuren sind der Codeträger und die Abtasteinrichtung um eine Achse durch den Flächenmittelpunkt des Codeträgers oder den Mittelpunkt oder Schwerpunkt der Anordnung angeordnet, wobei entweder Codeträger oder Abtasteinrichtung um diese Achse drehbar sind. Die Achse wird im Weiteren jedoch nicht mehr bezeichnet und erläutert.

In den Figuren 5A-5D sind Beleuchtungseinrichtungen für eine erfindungsgemässe Winkelmesseinrichtung in mehreren Varianten der Anordnung dargestellt. Die Beleuchtungseinrichtungen sind rein beispielhaft als Leuchtdioden dargestellt - es versteht sich, dass unterschiedlichste Strahlungsquellen einsetzbar sind, sowie auch die Beleuchtungseinrichtungen unterschiedlichst ausbildbar sind und beispielsweise weitere optische Elemente, wie Linsen oder Diffusoren, umfassen können.

Der Teilkreis T1 aus Figur 5A ist von innen her beleuchtet. Das Material des Teilkreises T1 ist hier Glas. Zum Schutz des Codes kann der Glaskreis mit einer Schutzschicht überzogen sein bzw. ein Schutzglas aufgeklebt sein. Durch die mittig innerhalb des Kreises angeordnete Leuchtdiode L wird der Kreis gleichmässig ausgeleuchtet. Licht tritt von innen durch den Kreis nach aussen in Richtung der Abtastfolie F3, welche die durch den Code beeinflussten Lichtsignale empfängt. Eine alternative Beleuchtungsform für eine derartige Anordnung ist mit einem selbstleuchtenden Code, welcher beispielsweise organische Leuchtdioden aufweist, realisierbar.

In Figur 5B umgibt der Teilkreis T2 konzentrisch die innere Abstastfolie F4. Wiederum erfolgt die Beleuchtung von der Mitte der Anordnung aus. Die Abtastfolie F4 weist zwischen lichtundurchlässigen lichtempfindlichen Bereichen lichtdurchlässige Bereiche auf, sodass Licht der mittig positionierten Leuchtdiode L durch die Folie auf die Mantelfläche des Teilkreises T2 trifft und dort reflektiert wird. Die lichtempfindlichen Bereiche der Folie empfangen die reflektierte Strahlung als positionsabhängiges Abtastsignal.

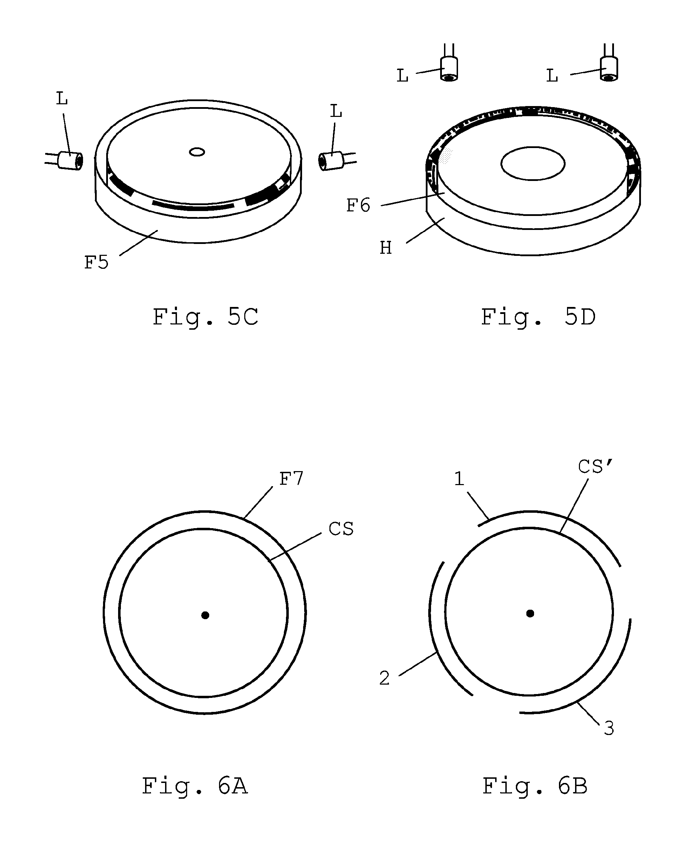

Figur 5C zeigt eine Darstellung mit einer äusseren Beleuchtung. Zwei Leuchtdioden L sind entlang der Umfangsfläche der Messeinrichtung positioniert und beleuchteten den Code durch die Folie F5, welche wiederum optisch teildurchlässig ausgebildet ist und die von der Codestruktur reflektierten Signale empfängt.

Die Beleuchtungseinrichtung aus Figur 5D umfasst zwei Leuchtdioden L, welche zur Beleuchtung von Hohlkreis-Codeträger H und Folie F6 schräg in den Zwischenraum derselben abstrahlen. Diese Art der Beleuchtung entspricht wiederum der Technik des Auflichtverfahrens - die schräg einfallende Strahlung wird am - codierten - inneren Umfang des Hohlkreises zur Folie F6 reflektiert.

Es versteht sich, dass als Beleuchtungseinrichtung in den Ausführungsbeispielen der Figuren 5C und 5D genauso eine einzige Leuchtquelle oder aber mehrere Leuchtquellen eingesetzt werden können.

In den Figuren 6A-6D sind rein schematisch vier Ausführungsbeispiele für mögliche Anordnungen von Codeträger und Abtasteinrichtung einer erfindungsgemässen Winkelmesseinrichtung dargestellt. Selbstverständlich ist eine Vielzahl weiterer alternativer Anordnungen möglich.

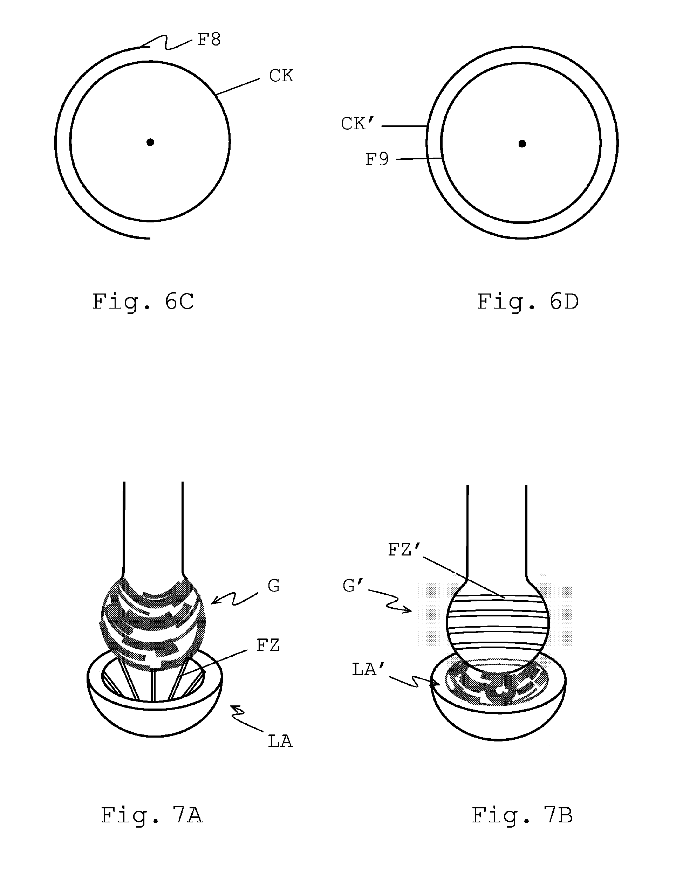

Figur 6A zeigt eine die Codeträger-Scheibe CS vollständig umgebende Abtastfolie F7, in Figur 6B ist die Abtastfolie dreistückig ausgebildet und symmetrisch um die Codescheibe CS' angeordnet, sodass jedes der drei Stücke 1,2,3 die Codescheibe CS' entlang eines Teilumfangs derselben in jeweils einem Umgreifwinkel von etwa 45° umgreift. Figur 6C zeigt eine Abtastfolie F8, die einstückig ist, den zylindrischen Codekörper CK aber nur halbseitig umgreift. Der von der Abtastfolie F8 aufgespannte Raum hat im Querschnitt die Form eines Halbmondes. Der Umgreifwinkel der Abtastfolie F8 beträgt hier 180°. In Figur 6D ist eine alternative Anordnung mit Hohlzylinder-Codekörper CK', welcher die - innere - Abtastfolie F9 vollständig umgreift, dargestellt. Das vollständige Umgreifen erhöht die Auflösung der Messung, indem über den gesamten Code integriert werden kann.

Die Figuren 7A und 7B zeigen zwei Ausführungsbeispiele einer erfindungsgemässen Winkelmesseinrichtung, mittels welcher Ausführungen die Winkellage eines Kugelgelenks in einer entsprechenden Lagerung feststellbar ist. In Figur 7A ist das Kugelgelenk G als Codeträger ausgebildet und das Lager LA mit Folienzeilen FZ als Abtasteinrichtung, in Figur 7B ist das Lager LA' der Codeträger und das - mit Folienzeilen FZ' umgebene - Gelenk G' die Abtasteinrichtung.

Die Ausführung eines Kugelgelenks mit abtastenden Foliensegmenten kann auch mit einem nutenartige Vertiefungen aufweisenden Kugelgelenk erfolgen, indem Foliensegmente in die Vertiefungen eingebracht werden. Ebenso können Codeelemente tiefenversetzt angeordnet werden. Die Ausführung des Lagers mit Folien- oder Codeelementen kann in analoger Art und Weise erfolgen. Mit derartigen Ausführungsformen ist eine Lagerreibung der Folien- und Codeelemente vermeidbar.

## Patentansprüche

1. Optoelektrische Winkelmesseinrichtung zur Bestimmung mindestens eines Winkels um mindestens eine Achse (A,A1,A2), mit
• einem die Achse (A,A1,A2) umgebenden Codeträger, der einen optisch erfassbaren Positionscode (C1,C2,C3) zumindest entlang eines Teilumfangs zur Achse (A,A1,A2) trägt, und
• einer Abtasteinrichtung mit mehreren zumindest in Teilumfangsrichtung beabstandeten lichtempfindlichen Flächenbereichen, mit welcher der Positionscode (C1,C2,C3) erfassbar ist und ein positionsabhängiges Abtastsignal, das mit dem Winkel zwischen dem Codeträger und der Abtasteinrichtung verknüpft ist, erzeugbar ist,
**dadurch gekennzeichnet, dass**
die Abtasteinrichtung den Codeträger oder der Codeträger die Abtasteinrichtung zumindest entlang eines Teilabschnitts des Teilumfangs umgreift.

2. Optoelektrische Winkelmesseinrichtung nach Anspruch 1,
**dadurch gekennzeichnet, dass**
die Abtasteinrichtung als einstückige Abtastfolie (F1,F2,F3,F4,F7,F8,F9) ausgebildet ist.

3. Optoelektrische Winkelmesseinrichtung nach Anspruch 2,
**dadurch gekennzeichnet, dass**
die Abtastfolie (F1,F2) als lichtempfindliche Flächenbereiche eine Vielzahl organischer Photodetektoren, beispielsweise Photodioden oder Photozellen, aufweist.

4. Optoelektrische Winkelmesseinrichtung nach Anspruch 2 oder 3, **dadurch gekennzeichnet, dass** die Abtastfolie (F4) zwischen den lichtempfindlichen Flächenbereichen lichtdurchlässige Bereiche aufweist.

5. Optoelektrische Winkelmesseinrichtung nach einem der vorangehenden Ansprüche, **dadurch gekennzeichnet, dass**
• die Abtasteinrichtung den Codeträger entlang dessen gesamten Umfangs vollständig umgreift oder
• der Codeträger die Abtasteinrichtung entlang deren gesamten Umfangs vollständig umgreift.

6. Optoelektrische Winkelmesseinrichtung nach einem der Ansprüche 1 bis 4, **dadurch gekennzeichnet, dass** mehrere, insbesondere in Umfangsrichtung voneinander beabstandet angeordnete, Abtasteinrichtungen vorgesehen sind.

7. Optoelektrische Winkelmesseinrichtung nach einem der vorangehenden Ansprüche, **dadurch gekennzeichnet, dass** der Positionscode (C1 C1,C2,C3) auf einer Mantelfläche (M,M1) des Codeträgers aufgebracht ist.

8. Optoelektrische Winkelmesseinrichtung nach einem der vorangehenden Ansprüche, **dadurch gekennzeichnet, dass** der Positionscode als inkrementeller oder absoluter Code ausgeführt ist.

9. Optoelektrische Winkelmesseinrichtung nach einem der vorangehenden Ansprüche, **dadurch gekennzeichnet, dass** der Positionscode als spiralförmiger Code (C3), der die Achse umschliesst und sich entlang der Achse erstreckt, ausgeführt ist.

10. Optoelektrische Winkelmesseinrichtung nach einem der vorangehenden Ansprüche,
**gekennzeichnet durch**
eine optische Beleuchtungseinrichtung zur mittel- und/oder unmittelbaren Beleuchtung des Codeträgers.

11. Optoelektrische Winkelmesseinrichtung nach Anspruch 10,
**dadurch gekennzeichnet, dass**
die Beleuchtungseinrichtung eine oder mehrere Leuchtquellen, beispielsweise Leuchtdioden (L), aufweist.

12. Optoelektrische Winkelmesseinrichtung nach Anspruch 10 oder 11, **dadurch gekennzeichnet, dass**
die Beleuchtungseinrichtung so angeordnet ist, dass der Codeträger
- von innen oder
- von aussen
beleuchtbar ist.

13. Optoelektrische Winkelmesseinrichtung nach einem der Ansprüche 1 bis 9, **dadurch gekennzeichnet, dass**
der Positionscode als selbstleuchtender Code ausgeführt ist.

14. Optoelektrische Winkelmesseinrichtung nach Anspruch 13,
**dadurch gekennzeichnet, dass**
der Positionscode eine Vielzahl organischer Leuchtdioden aufweist.

15. Verwendung einer optoelektrischen Winkelmesseinrichtung nach einem der Ansprüche 1 bis 14 in einem geodätischen Messinstrument.

16. Verwendung einer Abtastfolie, welche Abtastfolie als Kunststoff-Folie ausgebildet ist und ein Feld organischer Photodetektoren und ein koinzidierendes Feld organischer Transistoren aufweist, als Abtasteinrichtung in einer optoelektrischen Winkelmesseinrichtung nach einem der Ansprüche 1 bis 14.
